# EUROPEAN PATENT APPLICATION

(11) **EP 4 376 058 A1**
(43) Date of publication of application: **29.05.2024**
(21) Application number: 23207816.2
(22) Date of filing: 04.11.2023
(51) Int. Cl.: H01L 21/67, H01L 21/677, H01L 21/683

(54) **HYBRID BONDING OF A THIN SEMICONDUCTOR DIE**

(30) Priority: 18.11.2022 US 202217989775
(71) Applicant: ASMPT Singapore Pte. Ltd., Singapore 768924 (SG)
(72) Inventor: Yiu Ming, CHEUNG, Hong Kong Sar (HK); Man Hon, CHENG, Hong Kong Sar (HK); Siu Cheung, SO, Hong Kong Sar (HK); So Ying, KWOK, Hong Kong Sar (HK); Ming, LI, Hong Kong Sar (HK)
(74) Representative: Emerson, Peter James

(57) **Abstract**

When locating a semiconductor die on a substrate, the die is picked up and carried with a die-holding surface of a bonding tool having a protrusion. The protrusion of the bonding tool is configured to be movable between a retracted position within the die-holding surface and an extended position protruding from the die-holding surface. When the protrusion is located in the extended position, the die is bent when the bonding tool is carrying the die. Thereafter, the bonding tool is moved to flatten the die against the substrate while the substrate urges the protrusion to retract from the extended position towards the retracted position.

## Description

### Field of the Invention

The invention relates to a method of locating a semiconductor die on a substrate and a bonding tool having a protrusion for bonding a semiconductor die on a substrate.

### Background

A copper hybrid bonding process (sometimes referred to as hybrid bonding) provides bumpless interconnects between bond pads of a silicon die and a silicon substrate (or between bond pads of a pair of silicon substrates) by direct copper-to-copper bonding at room temperature for three-dimensional integrated circuit applications.

However, when performing such hybrid bonding between a silicon die and a silicon substrate, some problems may be encountered when trying to provide for void free bonding of dies in environments requiring contaminants to be below particularly low threshold amounts.

### Summary of the Invention

It is thus an object of this invention to seek to provide an arrangement which overcomes at least some of the aforementioned problems of the prior art.

According to a first aspect of the present invention, there is provided a method of locating a semiconductor die on a substrate, comprising the steps of: picking up and carrying the die with a die-holding surface of a bonding tool having a protrusion, the protrusion being configured to be movable between a retracted position within the die-holding surface and an extended position protruding from the die-holding surface, wherein the protrusion is located in the extended position for bending the die when the bonding tool is carrying the die; and moving the bonding tool to flatten the die against the substrate while the substrate urges the protrusion to retract from the extended position towards the retracted position.

The first aspect recognizes that a problem with some existing techniques is that the tools used to bend the die to provide the required void-free contact area between the die and the substrate can be unsuitable for use in applications requiring less than particular threshold amounts of contaminants and/or are unable to allow the die to contact the substrate in a way that provides for void-free contact across the entire surface of the die.

Accordingly, a method is provided. The method may be for locating a die on a substrate. The method may comprise picking up and carrying or holding the die. The die may be picked up and carried with a die-holding surface of a bonding tool. The die-holding surface of the bonding tool may have a protrusion, projection or extension. The protrusion may be configured to be moveable between a retracted position in which the protrusion is retracted or retained within the die holding surface and an extended position in which the protrusion protrudes or extends from the die holding surface. The protrusion may be located in the extended position to bend, curve or deform the die when the bonding tool carries the die. The method may comprise moving or translating the bonding tool to flatten, smooth or restore the shape of the die against the substrate. The moving may urge the protrusion to retract from the extended position towards the retracted position. In this way, a bonding tool which is not susceptible to inappropriate levels of contaminants can be provided, whose protrusion causes an initial deformation of the die to provide the required void-free initial contact zone between the die and the substrate. The contact zone can then be enlarged by moving the bonding tool towards the substrate to flatten the die against the substrate whilst causing the protrusion to become retracted within the bonding tool to enable a contact front between the substrate and the die to enlarge, to provide for void-free contact across the die.

The moving may comprise moving the bonding tool towards the substrate to contact the die against the substrate.

Locating the protrusion in the extended position may bend the die from a planar form to a convex form. Hence, the protrusion may help to bend or deform the die from its natural, unstressed, planar form into a convex or curved form.

The protrusion may be positioned to bend the die into the convex form by displacing a central region of the die relative to a periphery or edge region of the die. Hence, the central region may bulge towards the substrate compared to the edge of the die.

The extended position may bend the die away from the die-holding surface by a standoff amount.

The method may comprise biasing or predisposing the protrusion to the extended position with a biasing mechanism located within the die-holding surface. Accordingly, the protrusion may be biased to be urged towards the extended position to initially bend the die.

Moving the bonding tool to flatten the die against the substrate may comprise moving the bonding tool towards the substrate to initially contact the central region of the die against the substrate.

Moving the bonding tool to flatten the die against the substrate may overcome the biasing mechanism to retract the protrusion to the retracted position to allow contact between the die and the substrate to propagate from a region corresponding to a position of the protrusion towards a periphery of the die. Hence, pushing the bonding tool towards the substrate causes the die to contact against the substrate which in turn causes the protrusion to be pushed into the bonding tool.

The method may comprise continuing to move the bonding tool to fully retract the protrusion within the die-holding surface.

The die holding surface may be planar.

Fully retracting the protrusion within the die-holding surface may allow the die to return to the planar form.

Continuing to move the bonding tool may flatten the die against the substrate.

Carrying the die may comprise holding the periphery of the die against the die-holding surface to facilitate bending of the die into the convex form by the protrusion.

Carrying the die may comprise generating a vacuum force to hold the periphery of the die against the die-holding surface.

The vacuum force holding the periphery of the die may be configured not to overcome the biasing mechanism when the protrusion is in the extended position. In other words, the vacuum generated at the edge of the die is insufficient to prevent bending of the die by the protrusion.

The method may comprise ceasing to hold the periphery of the die against the die-holding surface to enable the die to remain in the planar form following contact between the die and the substrate to allow contact between the die and the substrate to propagate from the region corresponding to the position of the protrusion towards the periphery of the die.

According to a second aspect of the present invention, there is provided a bonding tool for locating a semiconductor die on a substrate, comprising: a die-holding surface for picking up and carrying the die, the die-holding surface having a protrusion that is configured to be movable between a retracted position within the die-holding surface and an extended position protruding from the die-holding surface, wherein the protrusion is located in the extended position for bending the die when the bonding tool is carrying the die; and an actuation mechanism configured to move the bonding tool to flatten the die against the substrate while the substrate urges the protrusion to retract from the extended position towards the retracted position.

Locating the protrusion in the extended position may bend the die from a planar form to a convex form.

The protrusion may be positioned to bend the die into the convex form by displacing a central region of the die relative to a periphery of the die.

The bonding tool may comprise a biasing mechanism located within the die-holding surface configured to bias the protrusion to the extended position.

The actuation mechanism may be configured to move the bonding tool towards the substrate to initially contact the central region of the die against the substrate.

The actuation mechanism may be configured to flatten the die against the substrate to overcome the biasing mechanism to retract the protrusion to the retracted position to allow contact between the die and the substrate to propagate from a region corresponding to a position of the protrusion towards a periphery of the die.

The actuation mechanism may be configured to continue to move the bonding tool to fully retract the protrusion within the die-holding surface.

The die-holding surface may be planar.

The actuation mechanism may be configured to continue to move the bonding tool to fully retract the protrusion within the die-holding surface to allow the die to return to the planar form.

The actuation mechanism may be configured to continue to move the bonding tool to flatten the die against the substrate.

The die holding surface may be configured to carrying the die by holding the periphery of the die against the die-holding surface to facilitate bending of the die into the convex form by the protrusion.

The apparatus may comprise a vacuum generator configured to generate a vacuum force to hold the periphery of the die against the die-holding surface.

The vacuum generator may be configured to generate the vacuum force so as to not overcome the biasing mechanism when the protrusion is in the extended position.

The vacuum generated may be configured to stop generated the vacuum force to cease holding the periphery of the die against the die-holding surface to enable the die to remain in the planar form following contact between the die and the substrate to allow contact between the die and the substrate to propagate from the region corresponding to the position of the protrusion towards the periphery of the die.

These and other features, aspects, and advantages will become better understood with regard to the description section, appended claims, and accompanying drawings.

### Brief Description of the Drawings

Embodiments of the present invention will now be described, by way of example only, with reference to the accompanying drawings, in which:
FIG. 1 shows a sectional view of a flat thin silicon die and flat silicon substrate;
FIG. 2 shows a sectional view of a polished copper bond pad;
FIG. 3 shows a bottom view of a bonding tool, illustrating a protruding tip and vacuum holes distribution;
FIG. 4 shows an off-plane sectional view of the bonding tool;
FIG. 5 shows a sectional view of the bonding tool with vacuum channel;
FIG. 6 shows a sectional view of the bonding tool as it picks up a thin silicon die and holds the die against its surface by vacuum suction;
FIG. 7 is a three-dimensional depiction of a convex surface curvature of the thin silicon die when it is held by the bonding tool with a central protruding tip;
FIG. 8 is a sectional view of the bonding tool and the thin silicon die when they are lowered such that the convex surface of the die is just touching on a flat surface of the silicon substrate;
FIG. 9 is a sectional view of the bonding tool and the thin silicon die when the vacuum suction of the tool is turned off so that the thin silicon die will flatten and restore to its unstressed state; and
FIG. 10 is a sectional view of the bonding tool and the thin silicon die when a normal compressive force is applied to the tool such that the protruding tip is pushed back and retracted.

In the drawings, like parts are denoted by like reference numerals.

### Detailed Description

The following may be useful background information that is helpful for understanding the techniques of some embodiments. As mentioned above, a copper hybrid bonding process (sometimes referred to as hybrid bonding) provides bumpless interconnects for bond pads between a silicon die and a silicon substrate by direct copper-to-copper bonding at room temperature for three-dimensional integrated circuit applications. The hybrid bonding process is typically a two-step process. First, the silicon die is pre-bonded onto the silicon substrate at room temperature. Second, a subsequent thermal annealing process for the pre-bonded die and substrate is performed with a specific annealing profile in an oven. For the pre-bonding process, the silicon die is held by a bond tool and precisely aligned to its bond position on the substrate. The substrate can be a silicon wafer, a silicon interposer or an active silicon die which is secured on a work chuck during the pre-bonding process. The pre-bond is performed by placing the silicon die on the substrate at the precise desirable location with an optimized compressive force at room temperature.

To obtain a sub-10 micron pitch pad interconnect, the placement alignment accuracy of the die on the substrate for the pre-bonding process should be at or better than 0.5 microns. In order to obtain a suitable bonding interface for the hybrid bonding process, the surfaces of the silicon die and the substrate have to be very clean and smooth, particle-free, and the surfaces need to be plasma activated. The surfaces are typically polished by Chemical-Mechanical Polishing (CMP) to a roughness (RA) of less than 0.5 nanometres for any dielectric surface layers. The surfaces are typically cleaned thoroughly with megasonic energized deionized water and then activated by nitrogen plasma treatment. When these smooth surfaces are brought to close proximity (typically less than 100 nanometres apart), van der Waals attraction between -OH radicals on the surfaces adheres the silicon die and the silicon substrate together. A perfect interface may be obtained if both surfaces are free of particles.

The bonding interface between the silicon die and the substrate consists of dielectric passivation and copper pads. The dielectric passivation may be provided by silicon oxide or silicon carbon nitride. The pre-bonding process brings the bonding surfaces together and lets the van der Waals attraction cause the initial bonding at the interfaces of the dielectric passivation. The pre-bonded arrangement is then placed in an oven for thermal annealing with a specific profile. The bonding between the dielectric interface of the die and the substrate will convert to covalent bonds during the subsequent thermal annealing process at a first elevated temperature, typically for more than an hour. The copper pads on both surfaces will join together forming perfect metallurgical interconnects between the silicon die and the silicon substrate as the arrangement in the oven is annealed, typically at an even higher second temperature according to the annealing profile.

In order to obtain a perfect bonding interface, a key requirement is the provision of particle and contaminant free bonding surfaces for both the silicon die and the substrate before they are brought together. However, other conditions can impact on providing a perfect void-free bonding interface. The materials used for the dielectric layer (typically SiOa or SiCN), the wet process used for removing a protective coating of a singulated silicon wafer, as well as the parameters used for the plasma surface activation play an important role for void-free copper hybrid bonding. The assembly process for bonding typically starts from the centre. The contact between the two bonding surfaces starts from the centre and then enlarges its contact area. The contact area between the bonding surfaces grows, typically radially from the central region towards the periphery until the contact area extends across the whole surface. This can help achieve a void free and perfect bonding interface for wafer-to-wafer bonding. However, due to the relative smaller die size of given thickness, this bonding process may not be able to be used to implement die-to-die and die-to-wafer bonding with a standard bonding tool.

One way to obtain a void-free bonding interface utilizes a deformable convex pick-up tool with a substantially convex contact surface. A flexible film or die is picked up and held on the deformable tool and held with a convex surface curvature by vacuum suction through holes on the tool. The flexible film or die, as well as the deformable tool, flattens when a downward compressive force is applied to the tool as the flexible film or die bears against the flat substrate. However, such a deformable pick-up tool is typically made of rubber material which has a poor surface roughness and may trap contaminants. Accordingly, this approach is not suitable for environments requiring lower than a threshold amount of contaminants. In another approach, the flexible film or die is bent to conform to a convex surface curvature of a non-deformable tool. However, with this approach the compressive force at the outer corners and along the peripheral edge of the die is minimal, since this tool is not deformable and so there is no direct compressive force acting in these regions.

Before discussing embodiments in any more detail, first an overview will be provided. Some embodiments provide a technique for locating a die on a substrate. A bonding tool is used to hold the die on a surface of the bonding tool. A surface of the bonding tool has a protrusion which can be moved from an extended position, which protrudes from the die-holding surface to initially bend or flex the die on the bonding tool. The protrusion is moved towards a retracted position to flatten the die on the substrate. Typically, the movement of the bonding tool towards the substrate causes the die to contact the substrate which, in turn, causes the protrusion to be moved to the retracted position as the die flattens on the substrate. This enables an initial area of the die to first contact an adjacent area of the substrate and for that contact area to enlarge as the protrusion retracts into the die-holding surface of the bonding tool. By fully retracting the protrusion, the bonding tool is able to apply pressure to peripheral edges of the die to ensure appropriate contact with the substrate across the whole surface of the die. This approach allows for a reliable initial contact between the die and the substrate, with a controlled expanding contact-front between the die and the substrate using a bonding tool which is suitable for bonding in environments requiring lower specified threshold amounts of contaminants, and which avoids the creation of undesired voids in bonding regions between the die and the substrate.

Hence, some embodiments provide a vacuum pick and place tool having a bonding tool with a flat or planar die-holding or contact surface typically with multiple vacuum holes and a retractable protruding tip typically located in a central region of the contact surface. A thin die can be picked up by this bonding tool using vacuum suction through the vacuum holes. The die is then held tightly on the contact surface by vacuum suction whilst its central region is being pushed out, bent or deformed by the protruding tip. The protruding tip is typically preloaded by a compliant structure which is resistive enough to withstand the compressive force on the die created by the vacuum suction. The protruding tip sticks out or extends from the contact surface of the bonding tool and pushes against the contacting rear side of the die to form a convex curvature on the bonding surface of the die. This curvature of the bonding surface assists in achieving a void-free dielectric bonding interface for hybrid bonding. At the commencement of the bonding process, with minimal contact force during initial touchdown when the die first contacts against the substrate, the convex surface curvature of the die provides an initial minimal contact area between the die and the substrate in the central region, which helps to avoid any voids. As the vacuum suction is reduced, the die will restore to its unstressed state and flatten itself on the substrate. A bond front between the die and the substrate will grow and propagate towards the edges of the die, closing the bonding interfaces. Additional normal downward compressive force can then be applied to drive the bonding tool towards the substrate until the protruding tip is totally retracted within the contact surface of the bonding tool and the flat contact surface of the bonding tool presses the die against the substrate with an appropriate compressive force.

This arrangement provides a bonding tool suitable for use in very clean environments where low contamination is required since it avoids the use of a rubber or other similarly flexible contact surface. Also, since the protrusion is fully retractable within the bonding tool, this enables the contact surface to provide a more uniform compression over the entire bonding interface during hybrid bonding in comparison to convex-shaped bonding tools which are unable to provide the appropriate compressive force at the corners and along the edges of the die. Therefore, this arrangement is more suitable for conducting hybrid bonding of configurations with either Sl0₂ or SICN interfacial dielectric layers.

### Die and Substrate

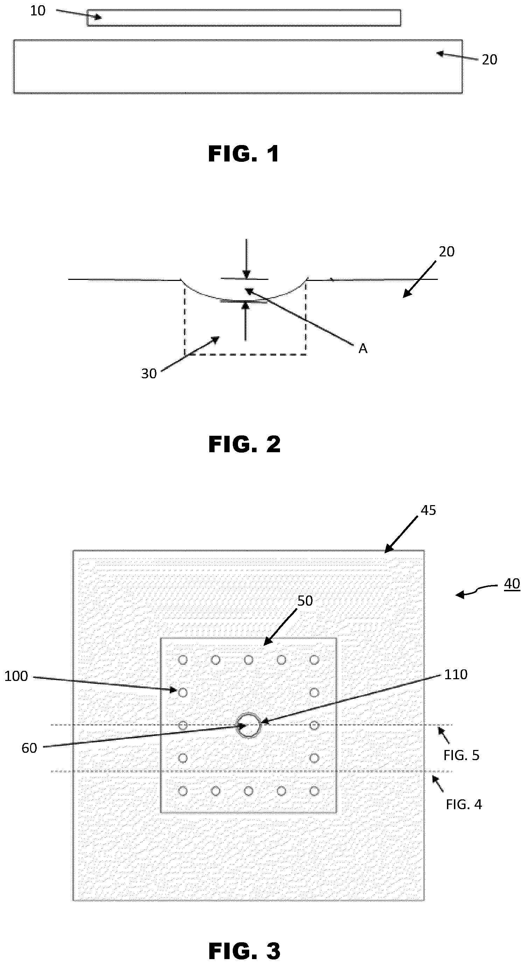

FIG. 1 is a sectional view showing a flat die 10 in its unstressed, free-standing or normal state and a flat substrate 20. In this example, the die 10 and the substrate 20 are both silicon. However, it will be appreciated that other types of die 10 and substrate 20 may be used in hybrid bonding. Both the die 10 and the substrate 20 contain dielectric passivation layers and copper bond pads on their bonding surfaces. To improve clarity, these structures have not been shown in this schematic representation. Typically, the dielectric layer can be Si0₂ made from a TEOS structure or an SiCN layer typically having a thickness of greater than around 200 nanometres. These dielectric bonding surfaces are typically polished by a Chemical Mechanical Polishing (CMP) process to achieve a very flat surface with a surface roughness (RA) of typically less than around 0.5 nanometres. However, the CMP polishing surfaces of copper bond pads 30 are typically recessed below the surface of the dielectric layer with a certain asperity as shown in FIG. 2. The recessing of the polishing copper pads 30 is often described as dishing of the copper bond pads 30 resulting from the CMP process. The depth A of dishing depends typically on the diameter of the copper bond pads 30 and the process control of the CMP process. A typical value of dishing depth is around 5-8 nanometres for copper bond pads having a 5 micrometre diameter.

### Bonding Tool

FIG. 3 illustrates schematically a plan view of a bonding tool 40, according to one embodiment. The bonding tool 40 has a tool base 45 which defines a die-holding surface 50. The die-holding surface 50 is flat or planar and is dimensioned to receive substantially the whole surface of the die 10 (not shown) to be bonded to the substrate 20 (not shown). That is to say, typically the die holding surface 50 is dimensioned to extend substantially to at least the outer peripheral edges of the die 10. A convex tip or protrusion 60 is positioned in a central aperture 110 located in a central region of the die-holding surface 50. A plurality of vacuum apertures 100 is formed around an inside periphery of the die-holding surface 50 for generating a vacuum suction force to hold the die 10.

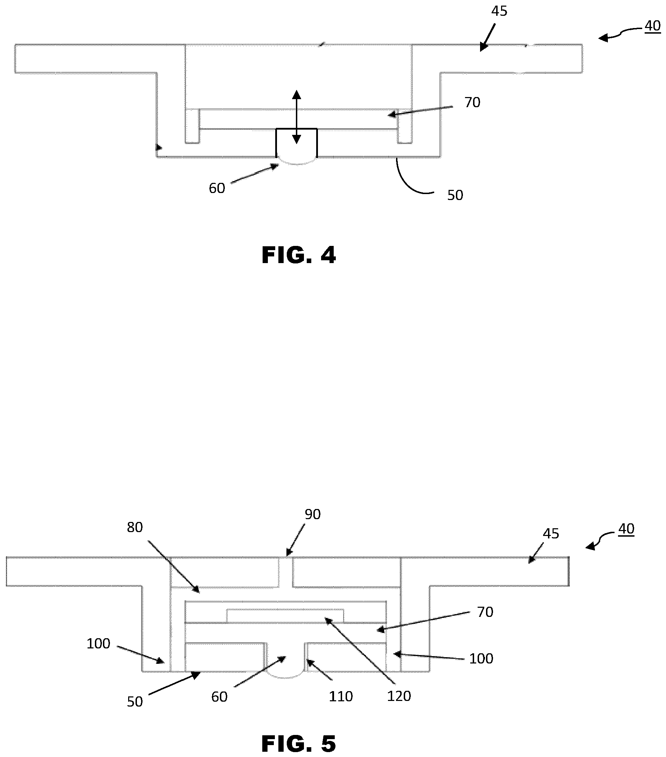

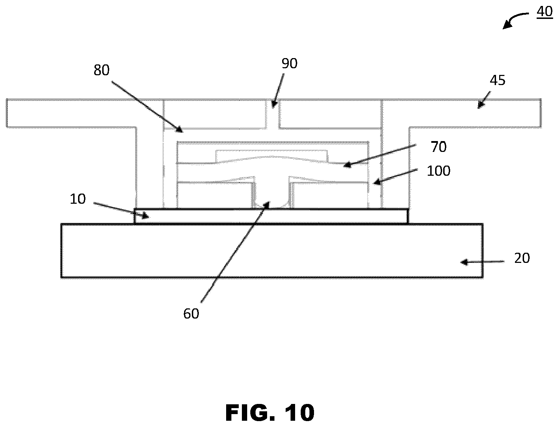

FIG. 4 illustrates schematically a sectional view through the bonding tool 40. The protrusion 60 is displaceable between an extended position as shown in FIG. 4 and a retracted position where the protrusion 60 is fully recessed within the bonding tool 40 (see FIG. 10). In other words, the protrusion 60 does not protrude from the die holding surface 50 when in the retracted or recessed position. A biasing mechanism 70 is provided within the tool base 45 which is resilient to urge the protrusion 60 towards the extended position as shown in FIG. 4. However, the resilient characteristics of the biasing mechanism 70 are selected such that an appropriate force on the protrusion 60 can overcome the urging force generated by the biasing mechanism 70 on the protrusion 60, such that the protrusion 60 moves from the extended position to the retracted position within the bonding tool 40, as will be explained in more detail below.

FIG. 5 illustrates schematically another sectional view of the bonding tool 40. The tool base 45 defines vacuum conduits 80 which couple a vacuum port 90 with the plurality of vacuum apertures 100 defined by the die-holding surface 50. Hence, it can be seen that the tool base 45 has a flat bottom surface provided by the die-holding surface 50, a convex tip provided by the protrusion 60 at its centre and vacuum holes provided by the vacuum apertures 100 on the flat surface around the protruding tip. As mentioned above, the protrusion 60 is connected to a biasing mechanism 70 which acts as a spring.

The vacuum apertures 100 communicate with a vacuum source via the vacuum conduits 80 and the vacuum port 90. If there is a force pressing against the protrusion 60, such force will be operative to retract the protrusion 60 into the central aperture 110 defined in the die-holding surface 50 as the biasing mechanism 70 is bent inwards into a cavity 120 inside the tool base 45. Since the deformation of the biasing mechanism 70 is elastic in nature, it will restore to its original configuration as the compressive force is removed and the protrusion will again be urged to protrude from the die holding surface 50.

Hence, it will be appreciated that when the die 10 is retained in position on the die-holding surface 50, the protrusion 60 will be urged by the biasing mechanism 70 to the extended position which flexes the die 10 into a convex configuration with a central portion of the die 10 in the vicinity of the protrusion 60 being positioned furthest away from the die-holding surface 50. As the die 10 contacts the substrate 20, the central portion of the die 10 will first contact the substrate 20 and continued movement of the die 10 with respect to the substrate 20 will generate a compression force which overcomes the force generated by the biasing mechanism 70 and causes the protrusion 60 to move towards the retracted position. This causes a gradual flattening of the die 10 against the substrate 20 and enlarges a bonding front between the die 10 and the substrate 20 from the initial central region towards the outer peripheral edges of the die 10. Eventually, the entire die 10 is fully flattened by the die holding surface 50 against the substrate 20, as will be explained in more detail below.

### Bonding Tool Operation

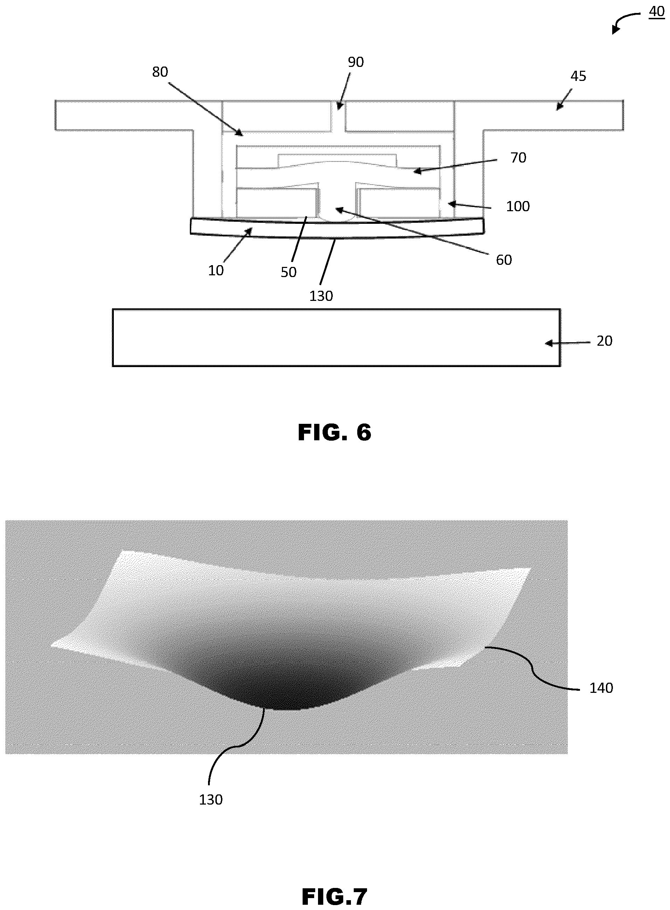

As can be seen in FIG. 6, following pick-up of the die 10, the die 10 is held against the die-holding surface 50 by a vacuum suction provided by the vacuum apertures 100. However, the die 10 does not lay flat against the die holding surface 50 due to the operation of the protrusion 60 in a central region 130 of the die 10 which pushes the central region 130 of the die 10 away from the die-holding surface 50. Typically, the protrusion 60 extends from the die-holding surface 50 by around 30 to 40 microns.

When the die 10 is held against the die-holding surface 50 by vacuum suction force, the protrusion slightly retracts such that it extends from the die-holding surface 50 by around 20 microns. It will be appreciated that the amount by which the protrusion 60 extends from the die-holding surface 50 and the stiffness of the biasing mechanism 70 should not be too large, otherwise it may not be possible to build up sufficient vacuum suction on the chip 10 during the pick-up process, even for dies of less than 250 micron thickness.

The die 10 is deformed when held by the vacuum on the die holding surface 50 and forms a convex surface curvature similar to that illustrated in FIG. 7 following successful pick-up by the bonding tool 40. The convex surface curvature generated at the central region 130 of the die 10 relative to peripheral edges 140 thereof facilitates the provision of a void-free hybrid bonding process.

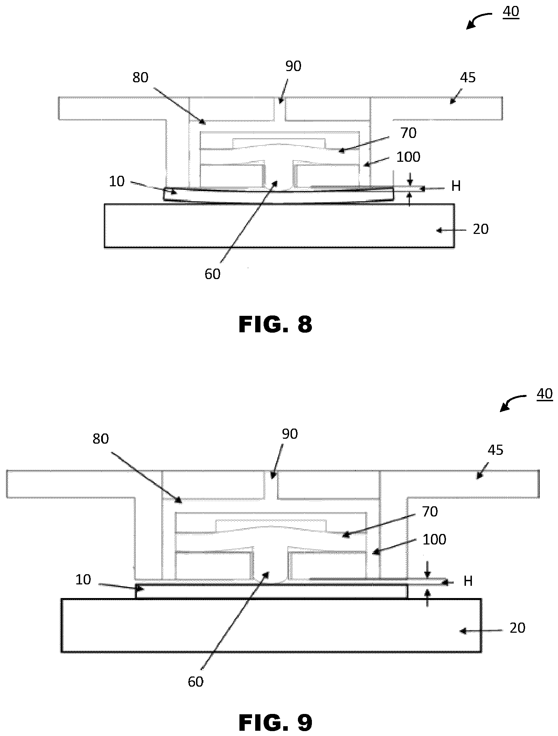

As shown in FIG. 8, as the bonding tool 40 approaches the substrate 20 the central region 130 of the die 10 makes an initial contact with the substrate 20 forming a void-free interfacial bonding area. The size of the initial interfacial bonding area is determined by the shape and configuration of the protrusion 60, the urging force generated by the biasing mechanism 70 and the contact force acting on the bonding tool 40. This contact force introduces an initial compression to the protrusion 60 and hence reduces its height. Therefore, the contact force should be low enough to ensure that the height H of the protrusion is sufficiently large to maintain a small initial central contact area when the die 10 with the convex central region 130 touches down and makes initial contact with the substrate 20. The height H of the stand-off can be optimized for the bonding process and is controllable by the compressive force acting on the bonding tool.

As shown in FIG. 9, once the initial contact has been made, the vacuum suction is typically switched off. This allows the die 10 to be released from the vacuum suction and to restore to its unstressed form and return to a flattened, planar configuration. As the die 10 flattens, the contact region of the interface between the die 10 and the substrate 20 grows, enlarging from the central region 130 with a bonding front moving outwards until it reaches the outer peripheral edges 140 of the die 10. This helps to achieve a void-free bonding interface between the dielectric layers of the die 10 and the substrate 20.

As shown in FIG. 10, a higher compressive force is then applied by the bonding tool 40. This causes the protrusion 60 to further overcome the urging force generated by the biasing mechanism 70 and causes the protrusion 60 to become fully retracted within the tool base 45 such that it no longer protrudes from beyond the die-holding surface 50. The die holding surface 50 may then apply a uniform bonding pressure across substantially the entire surface of the die 10. Once the pre-bonding process has completed, the subsequent thermal annealing process can then take place.

This arrangement enables the height of the protrusion 60 from the die holding surface 50 to be controlled during touchdown by changing the contact force when the bonding surface of the die 10 makes initial contact with the substrate 20. This allows for the optimization of the bond profile to achieve a void-free bonding interface for the hybrid bonding process. In addition, the protrusion 60 can be totally retracted into the bonding tool when there is a sufficient amount of compressive force between the die 10 and the substrate 20, so as to provide a uniform bonding pressure to assist the completion of the pre-bonding process.

Hence, it can be seen that some embodiments provide for a copper hybrid bonding process used to realize bumpless interconnects between bond pads of the silicon die 10 and silicon substrate 20 by direct copper-to-copper bonding at room temperature. The pre-bond is achieved by placing the die 10 onto the substrate 20 with an optimized compressive force at room temperature. The contact between the two bonding surfaces starts from a centre of the die 10 and then enlarges its contact. The contact surface area grows radially from the centre towards the periphery of the die 10 until the contact surface covers the whole die 10. The bonding tool 40 of some embodiments has a flat contact surface 50 with multiple vacuum holes 100 and a retractable protruding tip 60 at its centre. The die 10 can then be held tightly on the flat contact surface 50 of the tool 40 by vacuum suction while its centre region 130 is pushed out by the central protruding tip 60 of the tool. The protruding tip 60 is preloaded by a compliant or biasing structure which is strong enough to withstand the compressive force of the die 10 created by the vacuum suction. The protruding tip 60 protrudes out of the flat surface 50 of the tool 40 and pushes against the back side of the die 10, forming a convex curvature on the bonding side of the die 10. When the vacuum suction of the bonding tool 40 is turned off, the die 10 will be restored to its unstressed state and flattens itself on the silicon substrate. During bonding, the bonding front will grow and propagate towards the peripheral edges 140 of the die 10, to close the bonding interfaces completely, while the protruding tip 60 can retract into the tool 40 due to the compressive bonding force.

Although the present invention has been described in considerable detail with reference to certain embodiments, other embodiments are possible.

Therefore, the spirit and scope of the appended claims should not be limited to the description of the embodiments contained herein.

## Claims

1. A method of locating a semiconductor die on a substrate, comprising the steps of:
picking up and carrying the die with a die-holding surface of a bonding tool having a protrusion, the protrusion being configured to be movable between a retracted position within the die-holding surface and an extended position protruding from the die-holding surface, wherein the protrusion is located in the extended position for bending the die when the bonding tool is carrying the die; and
moving the bonding tool to flatten the die against the substrate while the substrate urges the protrusion to retract from the extended position towards the retracted position.

2. The method of claim 1, wherein locating the protrusion in the extended position bends the die from a planar form to a convex form.

3. The method of claim 2, wherein the protrusion is positioned to bend the die into the convex form by displacing a central region of the die relative to a periphery of the die.

4. The method of claim 1, comprising biasing the protrusion to the extended position with a biasing mechanism located within the die-holding surface.

5. The method of claim 1, wherein moving the bonding tool to flatten the die against the substrate comprises moving the bonding tool towards the substrate to initially contact a central region of the die against the substrate.

6. The method of claim 4, wherein moving the bonding tool to flatten the die against the substrate overcomes the biasing mechanism to retract the protrusion to the retracted position to allow contact between the die and the substrate to propagate from a region corresponding to a position of the protrusion towards a periphery of the die.

7. The method of claim 1, comprising continuing to move the bonding tool to fully retract the protrusion within the die-holding surface.

8. The method of claim 1, wherein the die-holding surface is planar.

9. The method of claim 1, wherein fully retracting the protrusion within the die-holding surface allows the die to return to the planar form.

10. The method of claim 7, wherein continuing to move the bonding tool flattens the die against the substrate.

11. The method of claim 1, wherein carrying the die comprises holding a periphery of the die against the die-holding surface to facilitate bending of the die into the convex form by the protrusion.

12. The method of claim 1, wherein carrying the die comprises generating a vacuum force to hold a periphery of the die against the die-holding surface.

13. The method of any claim 12, wherein the vacuum force holding the periphery of the die is configured not to overcome the biasing mechanism when the protrusion is in the extended position.

14. The method of claim 11, comprising ceasing to hold the periphery of the die against the die-holding surface to enable the die to remain in the planar form following contact between the die and the substrate to allow contact between the die and the substrate to propagate from a region corresponding to a position of the protrusion towards the periphery of the die.

15. A bonding tool for locating a semiconductor die on a substrate, comprising:
a die-holding surface for picking up and carrying the die, the die-holding surface having a protrusion that is configured to be movable between a retracted position within the die-holding surface and an extended position protruding from the die-holding surface, wherein the protrusion is located in the extended position for bending the die when the bonding tool is carrying the die; and
an actuation mechanism configured to move the bonding tool to flatten the die against the substrate while the substrate urges the protrusion to retract from the extended position towards the retracted position.
